# EUROPEAN PATENT APPLICATION

(11) **EP 1 029 948 A2**
(43) Date of publication of application: **23.08.2000**
(21) Application number: 00301007.1
(22) Date of filing: 09.02.2000
(51) Int. Cl.: C25D 5/02, C23C 28/02, H01L 21/768

(54) **Using electroplated cu as cold layer for cold/hot deposition**

(30) Priority: 19.02.1999 US 253585
(71) Applicant: Applied Materials, Inc., Santa Clara, California 95054 (US)
(72) Inventor: Ding, Peijun, San Jose, California 95129 (US); Hashim, Imran, San Jose, California 95126 (US); Chiang, Tony, San Jose, California 95117 (US); Chin, Barry, Saratoga, California (US)
(74) Representative: Allard, Susan Joyce

(57) **Abstract**

The present invention provides exemplary methods of filling surface features on a substrate with copper. In one embodiment, a substrate (30) is provided having a trench or via (32). A barrier layer (40) is applied to an exposed surface of the substrate and a first copper layer (48) is electroplated to the barrier layer. In one aspect, a second copper layer (52) is deposited onto the first copper layer so that the first and second copper layers fill the surface feature. In another aspect, the substrate is heated after the electroplating step to heat flow the first copper layer to fill the surface feature.

## Description

The present invention relates generally to methods of depositing layers over a substrate having raised features, and more specifically, to the use of cold/hot techniques including electroplating to fill substrate surface features with copper.

A typical process for producing a multilevel integrated circuit structure having feature sizes in the range of 0.5 microns or less may include: blanket deposition of a dielectric material; patterning of the dielectric material to form openings; deposition of conductive materials, such as copper or aluminum, onto the substrate in sufficient thickness to fill the openings; and removal of excessive conductive materials from the substrate surface using chemical, mechanical, or combined chemical-mechanical polishing techniques. Recently, the use of copper has drawn increased interest as a conductive material because of copper's relatively low resistivity and high electromigration resistance.

As the size of semiconductor patterned metal features has become increasingly finer, it is particularly difficult to use the techniques known in the art to provide multilevel metallurgy processing. This is particularly true for the deposition of conductive materials to fill high aspect ratio surface features. Typical chemical vapor deposition (CVD), evaporation, and physical vapor deposition (PVD) techniques tend to produce voids, provide poor step coverage and/or present other difficulties when used to fill high aspect ratio surface features. For example, the CVD of copper may not provide good grain orientation in the high aspect ratio trench or via. This would result in poor electromigration properties. Further, the CVD of copper has high cost of ownership.

One technique that has achieved some degree of success for filling high aspect ratio features is a cold/hot sequential copper deposition. First, a cold layer of copper is deposited using either CVD or PVD techniques, followed by a hot copper deposition step. However, as previously noted, the CVD of copper can be rather expensive. Further, PVD copper as a cold layer has limited capability due to poor step coverage, in part due to the creation of overhang as further described in the detailed description.

Hence, it is desirable to provide methods of filling high aspect ratio surface features with copper that reduce or eliminate voids within the surface feature and permit high substrate processing throughput at relatively low costs compared to the existing techniques.

The present invention provides exemplary methods of filling surface features on a substrate with copper. More specifically, the present invention provides methods of using electroplated copper as the cold layer of a cold/hot deposition process to help fill surface features on a substrate in a manner encouraging high throughput at relatively low cost compared to CVD.

The methods of the present invention will be particularly useful for filling trenches having high aspect ratios that otherwise can be difficult to fill using solely physical vapor deposition techniques. The use of the term trench is intended to include trenches, vias, combinations thereof, and, in general, the space between raised features on a substrate. For features with generally vertical sidewalls, the aspect ratio is defined as the feature depth compared to the feature width or diameter. The present invention will be particularly useful for filling trenches having an aspect ratio that is between about 1:2 and about 6:1.

In one exemplary method of the present invention, a substrate, preferably a silicon oxide substrate, is provided having a trench to be filled with copper. A barrier layer is applied to an exposed surface of the substrate and a first copper layer is electroplated to the barrier layer. The electroplated copper layer will grow based on the underlying layer profile. A second copper layer is deposited onto the first copper layer using hot deposition so that the first and second copper layers fill the trench. Exemplary methods of depositing copper are described in U.S. Application Serial No. 08/855,059 (Applicant Reference No. AM-1811), filed May 13, 1997, and entitled "Method of Sputtering Copper to Fill Trenches and Vias", the complete disclosure of which is incorporated herein by reference.

The barrier layer preferably includes at least one material selected from a group of materials consisting essentially of titanium, titanium nitride, titanium silicon nitride, tungsten, tungsten nitride, tungsten silicon nitride, tantalum, tantalum nitride and tantalum silicon nitride. Such materials help prevent the diffusion of copper into the substrate. Preferably, the barrier layer is applied using a physical vapor deposition process. Alternatively, the barrier layer is applied using a chemical vapor deposition process.

The electroplating step preferably includes DC-pulsed or DC only electroplating using commercially available electrolytes, and further preferably occurs when the substrate has a temperature that is between about 25 degrees Celsius and about 100 degrees Celsius. The electroplating step preferably provides at least about 40 percent step coverage, and more preferably, about 100 percent step coverage. The term step coverage herein refers to both sidewall step coverage and bottom surface step coverage. It will be appreciated by those skilled in the art that the first copper layer has a thickness that will vary depending upon the particular trench and application. In one particular aspect, the first copper layer is about 1000 Angstroms thick. Preferably, the step of depositing the second copper layer further includes adjusting a temperature of the substrate to between about 200 degrees Celsius and about 600 degrees Celsius.

In one particular aspect, the method further includes the step of applying a copper seed layer to the barrier layer, preferably by using a PVD or CVD technique, although other processing techniques may be used within the scope of the present invention. Preferably, the seed layer is deposited onto the barrier layer under vacuum, without breaking the vacuum seal formed prior to applying the barrier layer. The first copper layer then is electroplated to the seed layer. The electroplated first copper layer will grow based on the seed layer profile. The seed layer operates to provide better adhesion and orientation for subsequently deposited layers.

In one particular method of the present invention, a substrate having a trench is provided. Barrier and copper seed layers are applied to the substrate as previously described, and a copper layer then is electroplated to the seed layer. Thereafter, the substrate is heated to a temperature that is between about 350 degrees Celsius and about 600 degrees Celsius to cause the copper layer to flow and fill the trench.

Other features and advantages of the invention will appear from the following description in which the preferred embodiment has been set forth in detail in conjunction with the accompanying drawings, provided by way of example.
Fig. 1 depicts cross sectional views of various surface features to be filled with copper according to methods of the present invention;
Figs. 2A-2C depict cross sectional views of a substrate having surface features filled with copper by prior art PVD techniques;
Figs. 3A-3D depict cross sectional views of a substrate having surface features filled with copper according to a method of the present invention;
Fig. 4 depicts a schematic view of an exemplary electroplating apparatus for use in the electroplating steps of the present invention; and
Fig. 5A-5D depicts cross sectional views of a substrate having surface features filled with copper according to an alternative method of the present invention.

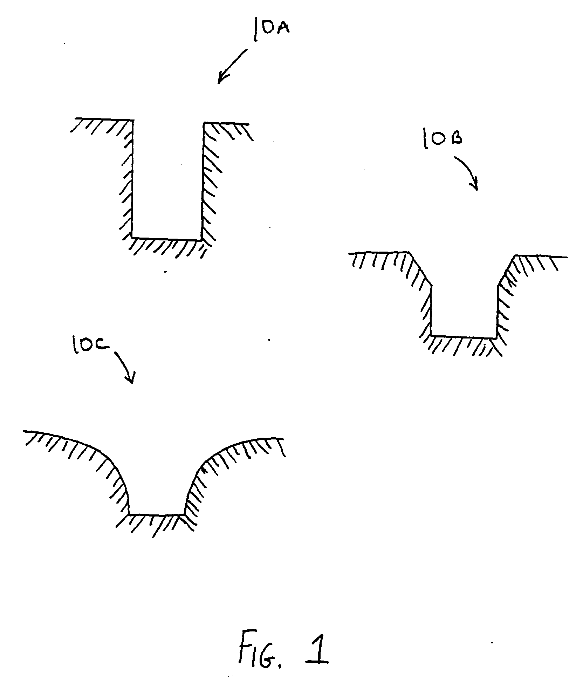

The present invention will be particularly useful for filling a wide range of surface features with copper, such as features 10A-10C depicted in Fig. 1. In particular, the present invention will be particularly useful for filling high aspect ratio surface features such as feature 10A. The use of the term trench is intended to encompass features 10A-10C and any space between raised features, e.g., openings for contacts and vias, that is to be filled with conductive materials according to methods of the present invention.

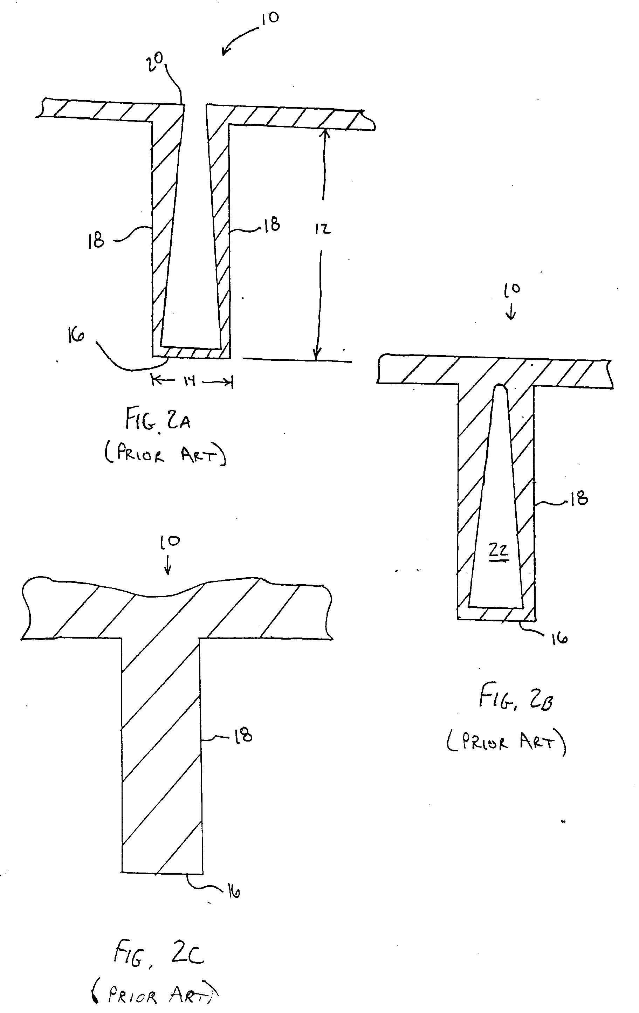

Figs. 2A-2C, depict the sputtering of copper to attempt to fill a trench 10 having a generally vertical sidewall 18, a depth 12, and a width or diameter 14 that create a high aspect ratio. The ratio of depth 12 to width/diameter 14 defines the aspect ratio of trench 10. Typically, the sputtering of copper to fill trench 10 creates an overhang 20. Overhang 20 results in the trench 10 opening having a smaller radius than the radius at the bottom of trench 10. As shown in Fig. 2B, the continued sputtering of copper closes the opening due to the lateral diffusion of copper atoms and surface tension. Once trench 10 opening is closed, the bulk diffusion of copper slowly fills trench 10 by way of a top-to-bottom filling procedure as shown in Fig. 2C. The rate of bulk diffusion typically does not facilitate high processing throughput for substrates.

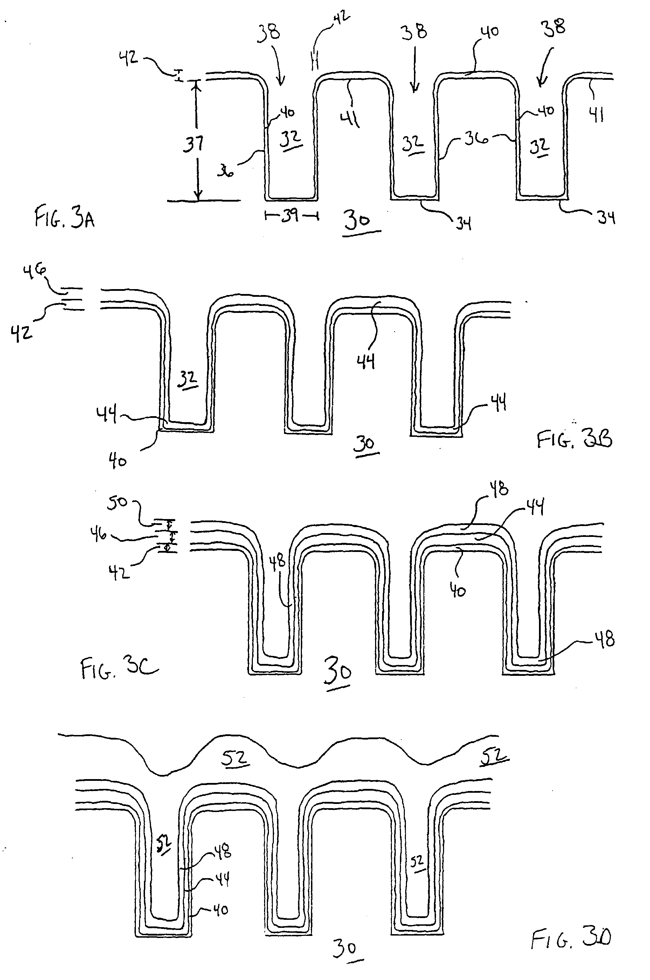

The present invention provides exemplary methods for filling trenches or vias with copper. One preferred method of the present invention will be described in conjunction with Figs. 3A-3D. A substrate 30 is provided having at least one trench 32 to be filled with copper. Each trench 32 has a bottom 34, a sidewall 36 and an opening 38. Trenches 32 are separated by an upper surface 41. A barrier layer 40 is first provided having a barrier layer thickness 42. The barrier layer 40 preferably comprises a material selected from a group of materials consisting essentially of titanium, titanium nitride, titanium silicon nitride, tungsten, tungsten nitride, tungsten silicon nitride, tantalum, tantalum nitride, and tantalum silicon nitride. Barrier layer 40 operates to prevent the diffusion of copper into substrate 30. Barrier layer 40 further operates as an adhesion layer and orientation layer for subsequently deposited layers. Barrier layer 40 may be applied using a chemical vapor deposition process. More preferably, barrier layer 40 is applied using a physical vapor deposition process, such as sputtering. For substrates have minimum feature sizes, i.e. a minimum trench width/diameter 39, of about 0.18 micron to 1.0 micron, barrier layer thickness 42 is generally between about 100 Angstroms and about 500 Angstroms, although other thicknesses may be used within the scope of the present invention.

As shown in Fig. 3B, a copper seed layer 44 is deposited over barrier layer 40. Seed layer 44 has a seed layer thickness 46 that is preferably between about 200 Angstroms and about 2000 Angstroms, for feature sizes that are generally between about 0.18 microns and about 1.0 microns. In one embodiment, seed layer thickness 46 is about 1500 Angstroms. Seed layer 44 may be deposited using CVD or PVD techniques. Preferably, seed layer 44 is deposited using a PVD approach such as a sputtering technique selected from a group of techniques consisting essentially of traditional sputtering, longthrow sputtering, coherent sputtering, IMP sputtering, and self-sustained sputtering. Seed layer 44 provides improved adhesion and orientation for subsequently deposited layers.

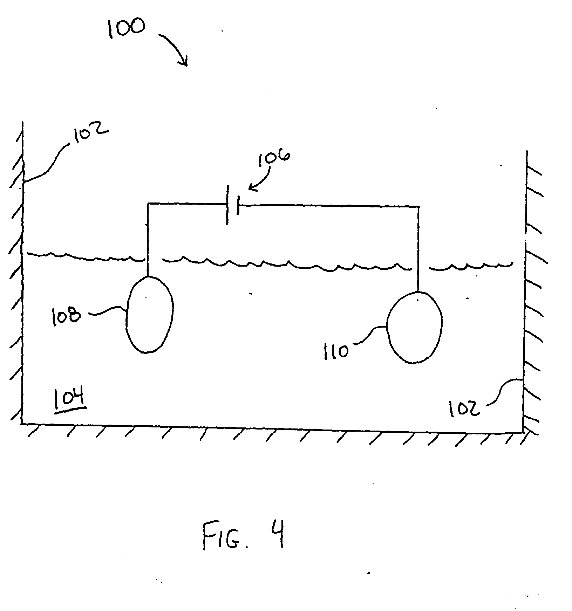

As shown in Fig. 3C, a first copper layer 48 then is electroplated to seed layer 44. By electroplating first copper layer 48, as further described in conjunction with Fig. 4, first copper layer 48 does not produce an overhang of copper material into opening 38 as is likely with the PVD of copper (as depicted in Fig. 2A). As a result, the deposition of a subsequent copper layer or layers results in copper being deposited in trench 32. Further, the use of an electroplating step provides for higher substrate 30 processing throughput and is less costly than CVD techniques. For example, a higher deposition rate for first copper layer 48 can be achieved using electroplating compared to CVD. Further, electroplating can occur in a non-vacuum system, thereby increasing system throughput by avoiding the need to form vacuum environments prior to deposition of first copper layer 48. Preferably, first copper layer 48 has a first copper layer thickness 50 that is between about 500 Angstroms and about 2000 Angstroms for feature sizes that are generally between about 0.18 microns and about 1.0 microns. In one embodiment, first copper layer thickness 50 is about 1000 Angstroms.

The use of an electroplating step further provides exemplary step coverage. For example, the electroplating step preferably provides about 70 percent step coverage by first copper layer 48, and more preferably, about 100 percent step coverage. This applies to both sidewall step coverage and bottom surface step coverage. Sidewall step coverage is the ratio of thickness 50 of first copper layer 48 along sidewall 36 compared to thickness 50 of first copper layer 48 along upper surface 41. Similarly, bottom surface step coverage is the ratio of thickness 50 of first copper layer 48 along bottom 34 of trench 32 compared to thickness 50 of first copper layer 48 along upper surface 41. Preferably, the electroplating step occurs when substrate 30 has a temperature that is between about 25 degrees Celsius and about 100 degrees Celsius.

As shown in Fig. 3D, a second copper layer 52 is deposited to complete the filling process of trench 32. Preferably, second copper layer 52 is deposited using a PVD technique, although CVD and other techniques may be used within the scope of the present invention. During the deposition of second copper layer 52, substrate 30 is maintained at a temperature that is between about 200 degrees Celsius and about 600 degrees Celsius, and more preferably, between about 300 degrees Celsius and about 600 degrees Celsius. An exemplary system for depositing barrier layer 40, seed layer 44 and second copper layer 52 is provided in U.S. Patent No. 5,186,718, assigned to Applied Materials, Inc., assignee of the present invention, the complete disclosure of which is incorporated herein by reference. Second copper layer 52 may be provided using a variety of PVD techniques, such as traditional sputtering, longthrow sputtering, coherent sputtering, IMP sputtering, and self-sustained sputtering.

Removal of excessive conductive materials, including excessive second copper layer 52, can then occur using chemical, mechanical, or combined chemical-mechanical polishing (CMP) techniques. Although the invention is not intended to be limited as such, after CMP first and second copper layers 48, 52 preferably do not extend over upper surfaces 41 for substrates 30 having trenches 32 with generally vertical sidewalls 36.

It will be appreciated by those skilled in the art that the optimum thickness of layers 40, 44, 48 and 52 will depend on the feature size and aspect ratio. In one particular embodiment, barrier layer 40 fills between about 2 percent and about 5 percent of trench 32; seed layer 44 fills between about 5 percent and about 10 percent of trench 32; first copper layer 48 fills between about 40 percent and about 60 percent of trench 32; and second copper layer 52 fills between about 30 percent and about 50 percent of trench 32.

Turning now to Fig. 4, one particular embodiment of an electroplating apparatus 100 for use with the methods of the present invention will be described. It will be appreciated by those skilled in the art that other electroplating apparatus may be used within the scope of the present invention. Electroplating apparatus 100 includes a cell 102 containing an electrolyte solution 104. A pulsed DC or DC only source 106 is connected to an anode 108 and a cathode 110. Cathode 110 includes substrate 30. Most conventional copper electroplating solutions may be used. In one embodiment, the electroplating solution includes Cu₂⁺⁺, SO₄ and H₂O. The anodes are typically contained in filtering bags (not shown) to prevent contamination of the electroplating solution by particulate matter which results during anode dissolution. Anodes of any suitable material may be used, for example, titanium anode baskets containing copper metal may be used.

A potential difference is established between anode 108 and cathode 110/substrate 30 which results in the dissolution of copper from anode 108, passage of copper ions from anode 108 to substrate 30 and the deposition of copper onto the exposed portion of substrate 30. For example, copper deposits on substrate 30 over the portions of seed layer 44 that are exposed, including surfaces of trench 32. Deposition of copper continues until the desired first copper layer thickness 50 is achieved. Then etch, chemical-mechanical polishing techniques and the like may be used to remove copper from undesired areas of substrate 30.

The use of electroplating a cold copper layer followed by PVD of a hot copper layer provides a number of advantages. First, there is a lower cost of ownership because both PVD and electroplating are cheaper processes compared to CVD. Second, the techniques of the present invention are extendible to extremely high aspect ratios because of the complimentary step coverage of PVD and electroplating processes. Further, high substrate throughput can be achieved because of the high deposition rates for PVD and electroplating.

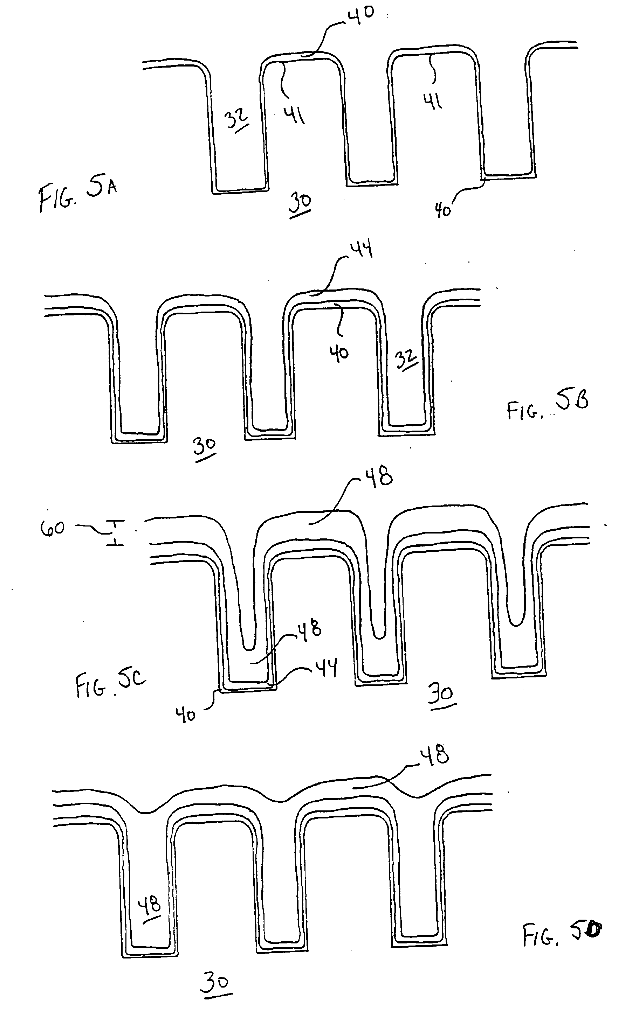

Turning now to Figs. 5A-5D, an alternative method according to the present invention will be described. As shown in Figs. 5A and 5B, substrate 30 having at least one trench 32 is provided. Barrier layer 40 and seed layer 44 are deposited as previously described in conjunction with Fig. 3. An electroplating step is used to deposit copper layer 48 having a thickness 60 over seed layer 44 as shown in Fig. 5C. As can be seen by comparing Fig. 5C and Fig. 3C, copper layer 48 is deposited such that copper layer thickness 60 is greater than copper layer thickness 50 provided by the method described in conjunction with Fig. 3. After the electroplating step deposits copper layer 48, substrate 30 is heated to between about 350 degrees Celsius and about 600 degrees Celsius to flow copper layer 48 and fill trench 32. More specifically, in one aspect, the flow process includes surface diffusion of copper layer 48 to complete the filling of trench 32.

The invention has now been described in detail. However, it will be appreciated that certain changes and modifications may be made. Therefore, the scope and content of this invention are not limited by the foregoing description. Rather, the scope and content are to be defined by the following claims.

## Claims

1. A method of filling a surface feature on a substrate with copper, comprising the steps of:
providing a substrate having a trench;
applying a barrier layer to an exposed surface of said substrate;
electroplating a first copper layer over said barrier layer; and
depositing a second copper layer over said first copper layer, wherein said first and said second copper layers fill said trench.

2. A method as in claim 1, wherein said trench has an aspect ratio that is between about 1:2 and about 6:1.

3. A method as in claim 1, wherein said barrier layer comprises at least one material selected from a group of materials consisting essentially of titanium, titanium nitride, titanium silicon nitride, tungsten, tungsten nitride, titanium silicon nitride, tantalum, tantalum nitride, and tantalum silicon nitride.

4. A method as in claim 3, wherein said applying step comprises applying said barrier layer using a chemical vapor deposition process.

5. A method as in claim 3, wherein said applying step comprises applying said barrier layer using a physical vapor deposition process.

6. A method as in claim 1, wherein said electroplating step comprises DC-pulsed or DC only electroplating.

7. A method as in claim 1, wherein said electroplating step further comprises heating said substrate to a temperature that is between about 25 degrees Celsius and about 100 degrees Celsius.

8. A method as in claim 1, wherein said electroplating step provides at least about 40 percent step coverage.

9. A method as in claim 1, wherein said electroplating step provides at least about 90 percent step coverage.

10. A method as in claim 1, wherein said first copper layer has a thickness that is between about 500 Angstroms and about 2000 Angstroms.

11. A method as in claim 1, wherein said depositing step comprises depositing said second copper layer using a sputtering technique.

12. A method as in claim 1, wherein said depositing step further comprises adjusting a temperature of said substrate to between about 200 degrees Celsius and about 600 degrees Celsius.

13. A method as in claim 1, further comprising the step of depositing a copper seed layer over said barrier layer between said barrier layer and said first copper layer, and wherein said electroplating step comprises electroplating said first copper layer to said seed layer.

14. A method as in claim 13, wherein said applying said copper seed layer step comprises a chemical vapor deposition technique.

15. A method as in claim 13, wherein said applying said copper seed layer step comprises a physical vapor deposition technique.

16. A method as in claim 15, wherein said physical vapor deposition comprises a sputtering technique selected from a group of techniques consisting essentially of traditional sputtering, longthrow sputtering, coherent sputtering, IMP sputtering, and self-sustained sputtering.

17. A method of filling a trench on a substrate with copper, comprising the steps of:
providing a substrate having a trench;
applying a barrier layer to an exposed surface of said substrate;
depositing a copper seed layer over said barrier layer;
electroplating a first copper layer to said seed layer; and
depositing a second copper layer over said first copper layer, wherein said first and said second copper layers fill said trench.

18. A method as in claim 17, wherein said trench has an aspect ratio that is between about 1:2 and about 6:1.

19. A method of filling a trench on a substrate with copper, comprising the steps of:
providing a substrate having a trench;
applying a barrier layer to an exposed surface of said substrate;
applying a copper seed layer to said barrier layer;
electroplating a copper layer to said seed layer; and
heating said substrate to a temperature that is between about 350 degrees Celsius and about 600 degrees Celsius to flow said copper layer and fill said trench.

20. A method of filling a trench on a substrate with copper, comprising the steps of:
providing a substrate having a trench;
applying a barrier layer to an exposed surface of said substrate;
applying a copper seed layer to said barrier layer using physical vapor deposition;
electroplating a first copper layer to said seed layer, said first copper layer providing at least about 60 percent step coverage; and
depositing a second copper layer over said first copper layer using physical vapor deposition, wherein said first and said second copper layers fill said trench.
